# EUROPEAN PATENT APPLICATION

(11) **EP 4 694 610 A2**
(43) Date of publication of application: **11.02.2026**
(21) Application number: 25191217.6
(22) Date of filing: 23.07.2025
(51) Int. Cl.: H10B 12/00

(54) **SYSTEM AND METHODS FOR A DUAL INTERLAYER DIELECTRIC**

(30) Priority: 02.08.2024 US 202463679078 P; 08.11.2024 US 202418942375
(71) Applicant: Samsung Electronics Co., Ltd., Suwon-si, Gyeonggi-do 16677 (KR)
(72) Inventor: JEONG, Young Doo, San Jose, CA, 95134 (US); LEE, Don Koun, San Jose, CA, 95134 (US); KIM, Dongwan, San Jose, CA, 95134 (US); LEE, Siwoo, San Jose, CA, 95134 (US)
(74) Representative: Kuhnen & Wacker Patent- und Rechtsanwaltsbüro PartG mbB

(57) **Abstract**

Disclosed herein are methods, devices and systems including a first electrode, a second electrode extending parallel to the first electrode, a first dielectric material between the first electrode and the second electrode, a second dielectric material between the first electrode and the second electrode, a third electrode contacting the first electrode, the third electrode extending in a direction orthogonal to the first electrode and the second electrode, a fourth electrode contacting the second electrode, the fourth electrode extending in a direction orthogonal to the first electrode and the second electrode, with the first dielectric material between the third electrode and the fourth electrode and the second dielectric material between the first dielectric material and the third electrode, and the second dielectric between the first dielectric material and the fourth electrode.

## Description

### TECHNICAL FIELD

The subject matter disclosed herein relates to microelectronics and integrated circuits (IC) structures. More particularly, the subject matter disclosed herein relates to a semiconductor structure involving an interlayer dielectric including two or more materials.

### BACKGROUND

Semiconductor devices may be created using complex three-dimensional structures made up of sets of smaller components. Such components may include circuit components such as transistors, capacitors, etc. reproduced in large numbers and addressed using a matrix of intersecting lines. However, forming a three-dimension address matrix is complex and may face difficulties in forming both the conductive lines and ensuring sufficient isolation between the individual lines. It is further noted that background concepts discussed herein are for informational purposes only and are not intended to limit the present disclosure. Nor should the background or field described herein be intended to limit the disclosure herein to a particular use or concept.

### SUMMARY

An example embodiment provides a device including a first electrode, a second electrode extending parallel to the first electrode, a first dielectric material between the first electrode and the second electrode, a second dielectric material between the first electrode and the second electrode, a third electrode contacting the first electrode, the third electrode extending in a direction orthogonal to the first electrode and the second electrode, a fourth electrode contacting the second electrode, the fourth electrode extending in a direction orthogonal to the first electrode and the second electrode, with the first dielectric material between the third electrode and the fourth electrode and the second dielectric material between the first dielectric material and the third electrode, and the second dielectric between the first dielectric material and the fourth electrode. The first dielectric material may include one or more of a carbide, nitride or an oxide. The second dielectric material may include one or more of a carbide, nitride or an oxide. In some embodiments, the first dielectric material and the second dielectric material may comprise different materials. In some embodiments, the first electrode may comprise a vertical bit line electrode and the third electrode may comprise a cell electrode. In some embodiments, the first dielectric material may extend in a direction parallel to the first electrode, and the second dielectric material may extend in a direction parallel to the first electrode. The second dielectric material may be between the first dielectric material and the first electrode and the second dielectric material may be between the first dielectric material and the second electrode. In some embodiments, the second dielectric material may comprise an air gap.

In an example embodiment, a system may include a first electrode, a second electrode extending in a direction parallel to the first electrode, a dielectric interlayer between the first electrode and the second electrode, the dielectric interlayer defining an air gap, a third electrode may extend orthogonally to the first electrode and the second electrode, a fourth electrode may extend parallel to the third electrode, and the air gap may be between the third electrode and the fourth electrode. In some embodiments, the dielectric interlayer may include one or more of a carbide, nitride or oxide. In some embodiments, the dielectric interlayer may extend parallel to the first electrode, and the air gap may extend parallel to the first electrode. In some embodiments, the dielectric interlayer may extend parallel to the third electrode.

In an example embodiment, a method may include forming a trench, forming a first dielectric within the trench, depositing a second dielectric within the trench to form a mold, depositing a third dielectric within the mold, removing portions of the first dielectric to form one or more conductive openings, and depositing a conductor within the one or more conductive openings. In some embodiments, the first dielectric and the second dielectric are the same material. In some embodiments, the first dielectric and the third dielectric are the same material. In some embodiments, after depositing the conductor within the one or more conductive openings, removing the third dielectric to forms an air gap. In some embodiments, the deposition of the second dielectric within the trench to form the mold is performed by atomic layer deposition. In some embodiments, depositing the third dielectric within the mold may be performed by at least one of atomic layer deposition and chemical vapor deposition. In some embodiments, the first dielectric is a carbide, the second dielectric is a nitride and the third dielectric is an oxide. In some embodiments, prior to depositing the conductor within the one or more conductive openings, the one or more conductive openings may be enlarged by trimming at least one of the second dielectric and the third dielectric using a wet-etch process. In some embodiments, removing the first dielectric is performed using a dry-etch process.

### BRIEF DESCRIPTION OF THE DRAWING

In the following section, the aspects of the subject matter disclosed herein will be described with reference to example embodiments illustrated in the figures, in which:
FIG. 1A depicts a perspective view of a semiconductor structure according to various embodiments of the subject matter disclosed herein;
FIG. 1B depicts an enlarged perspective view of a semiconductor structure according to various embodiments of the subject matter disclosed herein;
FIG. 2A depicts a plan view of a semiconductor structure according to various embodiments of the subject matter disclosed herein;
FIG. 2B depicts a cross-section view of a semiconductor structure according to various embodiments of the subject matter disclosed herein;
FIG. 2C depicts a plan view of a semiconductor structure according to various embodiments of the subject matter disclosed herein;
FIG. 2D depicts a plan view of a semiconductor structure according to various embodiments of the subject matter disclosed herein;
FIGS. 3A-3I depict cross-section views of an example embodiment of a semiconductor structure at different stages of its manufacture;
FIG. 4 depicts a flowchart of a method forming a semiconductor structure according to various embodiments of the subject matter disclosed herein;
FIGS. 5A-5H depict cross-section views of an example embodiment of a semiconductor structure at different stages of its manufacture;
FIG. 6 depicts a flowchart of a method forming a semiconductor structure according to various embodiments of the subject matter disclosed herein;
FIGS. 7A-7J depict cross-section views of an example embodiment of a semiconductor structure at different stages of its manufacture; and
FIG. 8 depicts a flowchart of a method forming a semiconductor structure according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Three-Dimensional," etc.) may be interchangeably used with a corresponding non-capitalized version (e.g., "counter clockwise," "three-dimensional," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination.

As used herein, memory may refer to various forms of semiconductor memory including both volatile memory where data is lost when power is turned off, and non-volatile memory which may retain data after power is turned off. Examples of volatile memory may include forms of random-access memory such as static random-access memory (SRAM), dynamic random-access memory (DRAM), synchronous dynamic random-access memory (SDRAM), double data rate DRAM or DDR DRAM. Examples of non-volatile memory may include flash memory devices, read only memory (ROM), programmable read only memory (PROM), electronically programmable read only memory (EPROM), electronically erasable and programmable read only memory (EEPROM), phase-change random-access memory (Phase-change RAM), ferroelectric random-access memory (FRAM), and resistive random-access memory (RRAM).

As used herein, three-dimensional memory or 3D memory may refer to any form of memory, including both volatile and non-volatile memory, containing individual elements organized in three-dimensions. For example, multiple planes of memory cells may be stacked upon each other. As used herein, vertically-stacked dynamic random-access memory (VSDRAM) may refer to a three-dimensional structure of DRAM where individual layers of DRAM elements may be stacked upon each other. In some embodiments, 3D memory may be organized that the addressing matrix is orthogonal to the memory cells. That is, in some embodiment, each of the bit line, the word line, and capacitors may extend in a different direction, such that each direction is orthogonal to each other. In some embodiments, the vertical direction, that is the direction orthogonal to the plane of the substrate, may be parallel to the bit line, while in other embodiments the word line or the capacitors may extend in the vertical direction. As used herein, bit line, word line, read line, address line, grid, array, and matrix may be used interchangeably to describe the various electrodes organized to provide a signal where two lines intersect within a larger device.

As used herein, conductors or conductive materials may refer to a variety of conductive materials, including which materials may be used alone or in combination with other materials. In some embodiments the conductor includes a semiconductor material such as, silicon (Si), germanium (Ge), gallium arsenide (GaAs), indium phosphide (InP) or any other suitable material. In some embodiments, the conductor may include a metal such as copper (Cu), tungsten (W), titanium (Ti), either alone or in combination. In some embodiments, the conductor may include a combination of materials, including oxides and nitrides. Such a listing of elements is not intended to be exhaustive, and in other embodiments, any known other type of conductive material may be used.

As used herein, dielectrics or dielectric materials may refer to non-conductive materials, and may include materials such as various semiconductor materials and the carbides, nitride and oxides thereof, such as silicon nitride (Si₃N₄) or silicon dioxide (SiO₂). Such dielectric materials may have a relatively low relative permittivity (εᵣ), such as less than 10 (εᵣ <10), or less than 20 (εᵣ <20), or less than 30 (εᵣ <30), or less than 40 (εᵣ <40), or less than 50 (εᵣ <50), or less than 100 (εᵣ <100) and thus be a poor conductor. In some embodiments, a dielectric material may include a fluidic material. In some embodiments, a dielectric material may take the form of an air gap.

Disclosed herein are various embodiments of devices, systems and methods related to a dual isolation interlayer dielectric within a 3D memory device. A 3D memory device may have vertically oriented bit lines, the vertical bit lines formed from a conductor, and the vertical bit lines spaced apart by the dual isolation interlayer dielectric. The dual isolation interlayer dielectric may include a first dielectric and a second dielectric. In some embodiments, the first dielectric may be a liner dielectric, and the second dielectric may be a bulk dielectric. In some embodiments, the dual isolation interlayer dielectric may be formed primarily of the first dielectric, while in other embodiments, the dual isolation interlayer dielectric may be formed primarily of the second dielectric. In some embodiments, the second dielectric may be an air gap. The dual isolation interlayer dielectric and vertical bit lines may be formed by first forming a trench within a 3D memory device, the trench being orthogonal to the word line and capacitor orientations. Within the trench a liner layer may be deposited, followed by a sacrificial dielectric layer. The sacrificial dielectric layer may be etched to form a series of openings within the sacrificial dielectric layer extending vertically. Within the openings, the first dielectric may be deposited to form a liner covering the exposed surfaces of the openings. After the first dielectric is deposited, the second dielectric may be used to fill the rest of the openings. The remainder of the sacrificial dielectric may then be removed by etching, and a portion of at least one of the first dielectric and the second dielectric may be trimmed to form a set of conductive openings aligned with electrodes within the plane formed by the word line and capacitors. A conductive material may then be deposited within the conductive openings to form the vertical bit line, while the remaining portions of the first dielectric and second dielectric may form the dual isolation interlayer dielectric. In some embodiments, the second dielectric may be a sacrificial material and after the vertical bit line is formed, the second dielectric may be removed to form an air gap.

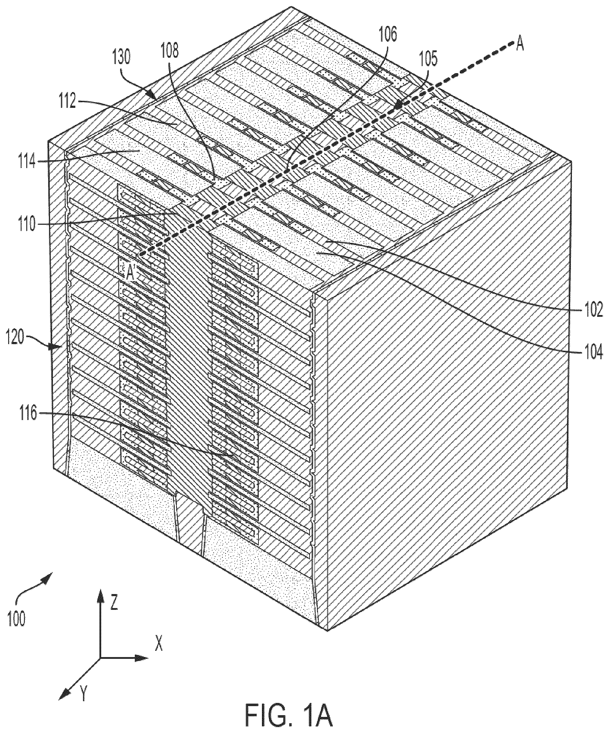

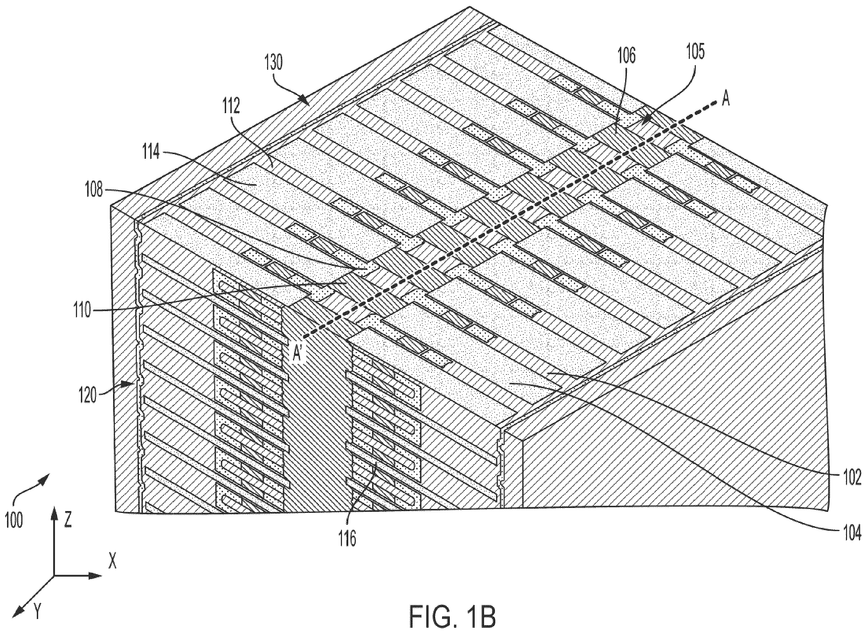

FIG. 1A depicts a perspective view of an example embodiment of a first semiconductor device 100. FIG. 1B depicts an enlarged perspective view of the first semiconductor device 100. The first semiconductor device 100 may form a portion of a 3D memory device, as well as any other suitable three-dimensional semiconductor devices. In the example of FIG. 1A, the 3D memory device may take the form of a vertically stacked device, where individual device layers 120 may be stacked upon each other. In some embodiments, the individual device layers 120 may take the form of a memory device such as DRAM, with the resulting 3D memory device of the first semiconductor device 100 taking the form of a vertically stacked DRAM. However, in other embodiments, the form of the individual device layers 120 may vary, and may include one or more layers such as SRAM, SDRAM, or any other suitable memory devices, either alone or in combination. In the example embodiment of FIG. 1A, the individual device layers 120 may be substantially similar to each other, while in other embodiments, the individual device layers 120 may differ from each other.

In the first semiconductor device 100, the addressing of individual elements such as capacitors, memory cells, or other suitable elements, may be done by use of one or more vertical electrodes 110 and one or more horizontal electrodes 116 to provide signals to one or more cell electrodes 130. In the example embodiment of FIG. 1A, the one or more vertical electrodes 110 extend parallel to the Z-axis, while the one or more horizontal electrodes 116 extend parallel to the Y-axis, and the one or more cell electrodes 130 extend substantially to the X-axis. In some embodiments, the one or more vertical electrodes 110 may be used as the bit line and the one or more horizontal electrodes 116 may be used as the word line. In other embodiments, the one or more vertical electrodes 110 may be used as the word line and the one or more horizontal electrodes 116 may be used as the bit line.

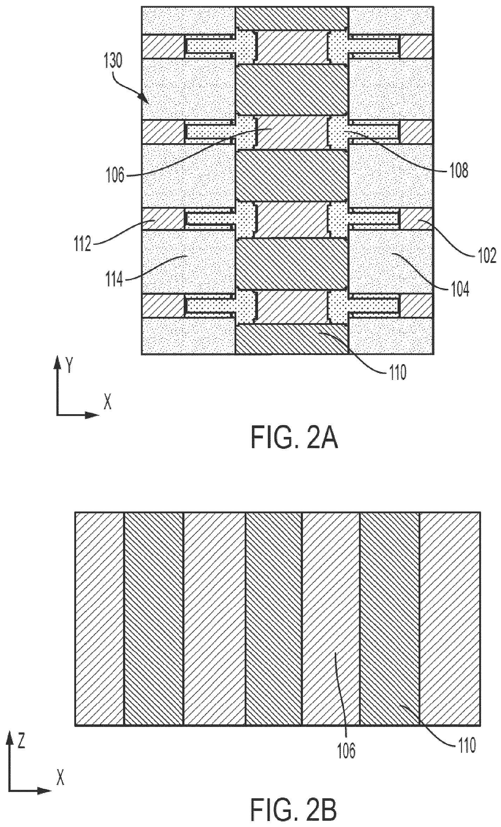

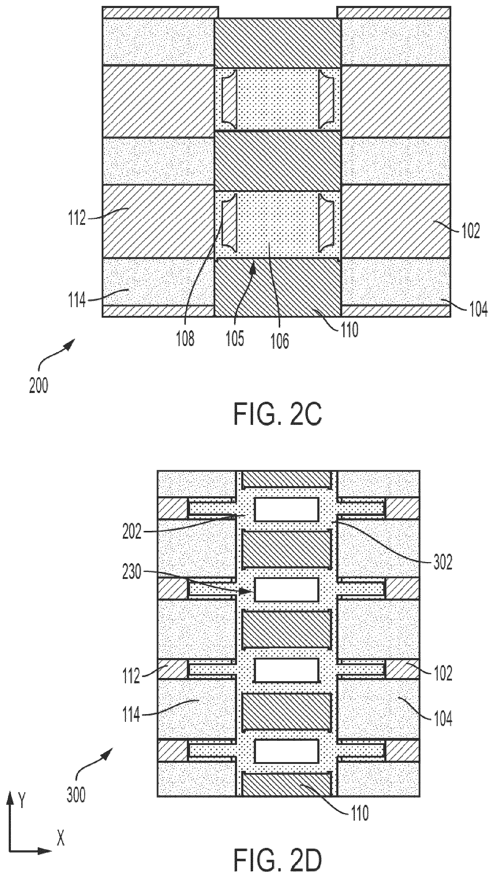

As shown in FIG. 1A, between each of the one or more vertical electrodes 110 an interelectrode isolation layer 105 is formed. The interelectrode isolation layer 105 may, in some embodiments, include one or more dielectric materials, including a first dielectric material 106 and a second dielectric material 108. In some embodiments, as shown below with respect to an example in FIG. 2A, the bulk of the interelectrode isolation layer 105 may be formed by the first dielectric material 106, while in other embodiments, as shown below with respect to an example in FIG. 2C, the bulk of the interelectrode isolation layer 105 may be formed by the second dielectric material 108. In some embodiments, the dielectric material used to form the first dielectric material 106 and the second dielectric material 108 may include semiconductor materials, as well as nitrides, carbides, and oxides thereof. In some embodiments, the first dielectric material 106 and the second dielectric material 108 may consist of silicon nitride, silicon oxide, or other similar materials such as gallium nitride, gallium oxide, and so forth. In some embodiments, the first dielectric material 106 and the second dielectric material 108 may consist of the same dielectric material, while in other embodiments, the first dielectric material 106 and the second dielectric material 108 may consist of different materials. In some embodiments, additional dielectric materials such as a third dielectric material or a fourth dielectric material may be formed within the interelectrode isolation layer 105.

The one or more cell electrodes 130 may be separated by the one or more vertical electrodes 110 into one or more source side cell electrodes 104 and one or more drain side cell electrodes 114. Although referred to as the drain side and the source side, in some embodiments, the one or more source side cell electrodes 104 may act as the drain, and the one or more drain side cell electrodes 114 may act as the source. The one or more source side cell electrodes 104 and the one or more drain side cell electrodes 114 may be made of a suitable conductive material for use in semiconductor processing, for example a semiconductor material such as a conductive silicon material like doped silicon, as well as metals, or any other suitable conductor, alone or in combination. In some embodiments, the one or more source side cell electrodes 104 and the one or more drain side cell electrodes 114 may be made of substantially the same material, while in other embodiments the one or more source side cell electrodes 104 and the one or more drain side cell electrodes 114 may be made of different materials.

In some embodiments, an isolation layer may be provided between each of the one or more cell electrodes 130. In some embodiments, one or more source side isolation layers 102 may be between each of the one or more source side cell electrodes 104. Similarly, in some embodiments, one or more drain side isolation layers 112 may be between each of the one or more drain side cell electrodes 114. In some embodiments, an isolation layer, like the one or more source side isolation layers 102 or the one or more drain side isolation layers 112, may be made of a dielectric material and may include semiconductor materials, as well as nitrides, carbides, and oxides thereof. In some embodiments, the one or more source side isolation layers 102 or the one or more drain side isolation layers 112 may consist of silicon oxide, silicon nitride, or other similar materials such as gallium nitride, gallium oxide, as well as combinations thereof. In some embodiments, the one or more source side isolation layers 102 or the one or more drain side isolation layers 112 may consist of the same dielectric material, while in other embodiments, the one or more source side isolation layers 102 or the one or more drain side isolation layers 112 may consist of different materials. In some embodiments, at least one of the one or more source side isolation layers 102 or the one or more drain side isolation layers 112 may be formed of substantially the same materials as one or more of the first dielectric material 106 and the second dielectric material 108, while in other embodiments, the materials of the one or more source side isolation layers 102 or the one or more drain side isolation layers 112 may differ from the first dielectric material 106 and the second dielectric material 108.

FIG. 2A depicts a plan view of an example embodiment of the first semiconductor device 100, with FIG. 2A differing from FIG. 1A by showing a view in the X-Y plane. FIG. 2A provides a closer view of the arrangement of the first dielectric material 106 and the second dielectric material 108. In the first semiconductor device 100, the first dielectric material 106 forms the bulk of the interlayer dielectric separating the one or more vertical electrodes 110. Additionally, the second dielectric material 108 forms a liner layer separating the one or more source side isolation layers 102 and the one or more drain side isolation layers 112 from the first dielectric material 106. In some embodiments, the second dielectric material 108 may extend on either side of the first dielectric material 106 beyond the one or more source side electrodes 104 or the one or more drain side cell electrodes 114, while in other embodiments the second dielectric material 108 may be even with one or more source side electrodes 104 or the one or more drain side cell electrodes 114.

FIG. 2B depicts a cross-section view of an example embodiment of the first semiconductor device 100, showing a view in the Z-Y plane along the line A-A' in FIG. 1A. In the example embodiment of FIG. 2B, the one or more vertical electrodes 110 are separated from each other by the first dielectric material 106, separating the one or more vertical electrodes 110 into a set of interdigitated electrodes. In some embodiments, the first dielectric material 106 may be selected to protect against a short between the one or more vertical electrodes 110. In some embodiments, the first dielectric material 106 may be selected to have a low relative permittivity (εᵣ) to protect against a parasitic capacitance between the one or more vertical electrodes 110

FIG. 2C depicts a plan view (X-Y plane) of an example embodiment of a second semiconductor device 200. The second semiconductor device 200 differs from the first semiconductor device 100 by the arrangement of the first dielectric material 106 and the second dielectric material 108. In the second semiconductor device 200, the first dielectric material 106 forms both the bulk of the interelectrode isolation layer 105 as well as a liner layer in contact with the one or more source side isolation layers 102 and the one or more drain side isolation layers 112. In some embodiments, the second dielectric material 108 may consist of two thin strips surrounded by the first dielectric material 106. In the second semiconductor device 200, the first dielectric material 106 may be chosen to be compatible with the material of the one or more source side isolation layers 102 and the one or more drain side isolation layers 112, while in other embodiments, an additional liner layer may exist between the first dielectric material 106 and the one or more source side isolation layers 102 and the one or more drain side isolation layers 112 to provide a compatible interface between the first dielectric material 106 and the one or more source side isolation layers 102 and the one or more drain side isolation layers 112.

FIG. 2D depicts a plan view of an example embodiment of a third semiconductor device 300. The third semiconductor device 300 differing from the first semiconductor device 100 and the second semiconductor device 200 by replacing the first dielectric material 106 and the second dielectric material 108 with a third dielectric material 202 and an air gap 230. In some embodiments, the third semiconductor device 300 may include a single dielectric material forming the third dielectric material 202, while in other embodiments a liner layer 302 may be used between the third dielectric material 202 and the one or more source side isolation layers 102 and the one or more drain side isolation layers 112 to provide a compatible interface between the third dielectric material 202 and the one or more source side isolation layers 102 and the one or more drain side isolation layers 112. The air gap 230 may be surrounded by the third dielectric material 202, with the air gap 230 providing a relative permittivity (εᵣ) close to one (εᵣ ~ 1). In some embodiments, a fluid may be introduced into the air gap 230, and may include a noble gas such as helium or argon, as well as a suitable liquid or other suitable fluid, while in other embodiments the air gap 230 may be kept empty. In some embodiments, the introduction of the air gap 230 may lower the relative permittivity (εᵣ) of the interelectrode isolation layer 105, and thus reduce the parasitic capacitance between the one or more vertical electrodes 110.

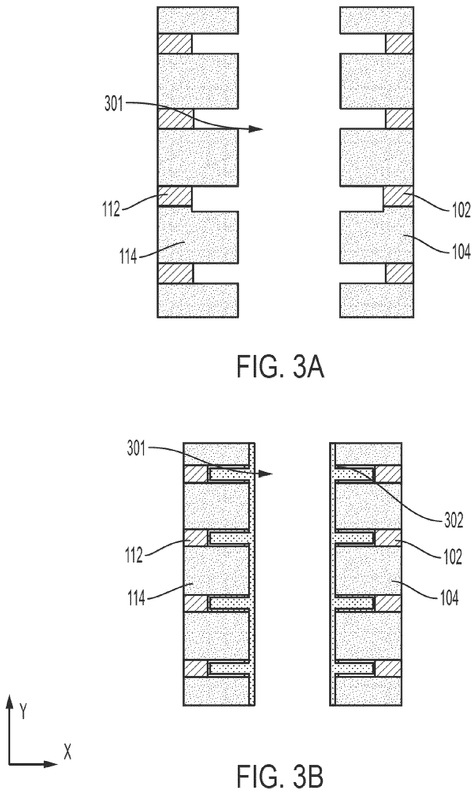

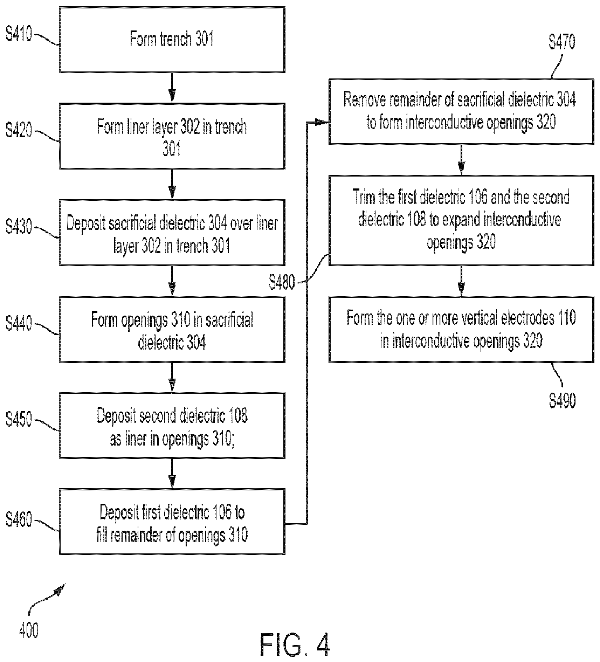

FIGS. 3A-3I depict an illustrative embodiment of a process of forming a semiconductor device such as the first semiconductor device 100, or any other semiconductor devices shown herein. FIG. 4 depicts a flowchart of a method forming the first semiconductor device 100, or any other semiconductor devices shown herein. FIG. 4 depicts an example embodiment of a process 400 for forming a semiconductor device corresponding to the illustrative embodiment of FIGS. 3A-3I.

FIG. 3A depicts S410 in the process of FIG. 4, where a trench 301 is formed within the first semiconductor device 100; the trench 301 separates the one or more cell electrodes 130 into the one or more source side cell electrodes 104 and the one or more drain side cell electrodes 114. The trench 301 may be formed using any suitable semiconductor process, and may include techniques such as etching, including both wet-etch processes using chemicals and dry-etch processes using reactive plasma, as well as lithography, mechanical drilling or cutting, lasers, and a combination of these methods and any other suitable methods known in the art. The trench 301 may have a width between the one or more source side cell electrodes 104 and the one or more drain side cell electrodes 114 of approximately 150 nm but may vary in other embodiments to a width of between 1 nm and 10 microns, as appropriate. In the embodiment of FIG. 3A, the trench 301 is depicted as extending between the one or more source side cell electrodes 104 and the one or more drain side cell electrodes 114, and may include a lateral recessing into the spaces between each of the one or more source side cell electrodes 104, each of the one or more drain side cell electrodes 114, or both. However, in some embodiments the trench 301 may not extend laterally beyond the one or more source side cell electrodes 104 or the one or more drain side cell electrodes 114, and may form a planar surface.

FIG. 3B depicts S420 in the process of FIG. 4, where the liner layer 302 is deposited over the surface of the trench 301. The liner layer 302 may be a conformal layer to cover exposed surfaces within the trench 301. The liner layer 302 may be formed by any suitable process, such as chemical vapor deposition (CVD), atomic layer deposition (ALD), or any other suitable method known in the art. In some embodiments, the material of the liner layer 302 may be chosen for depositional compatibility with the one or more source side isolation layers 102 and the one or more drain side isolation layers 112, and future processing steps. In some embodiments, the material of the liner layer 302 may be a dielectric material and may be substantially similar to the first dielectric material 106 or the second dielectric material 108. In some embodiments, the liner layer 302 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant.

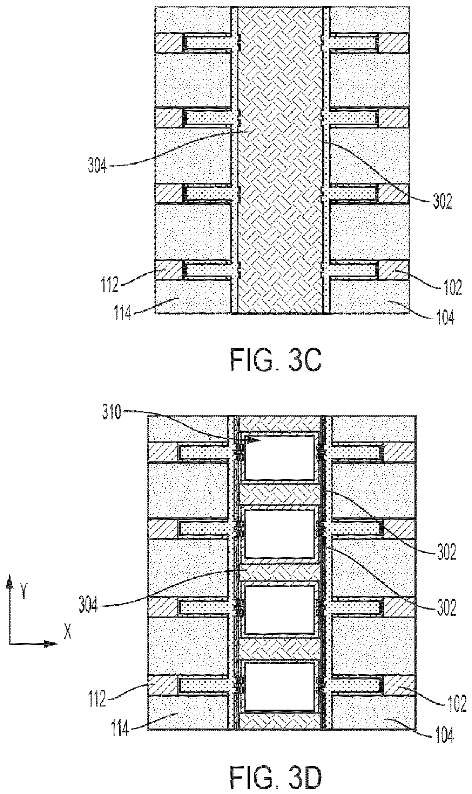

FIG. 3C depicts S430 in the process of FIG. 4, where a sacrificial dielectric 304 is deposited within the trench 301 and over the liner layer 302. The sacrificial dielectric 304 is deposited using a process such as CVD, ALD, or any other suitable method to fill the remainder of the trench 301. The sacrificial dielectric 304 may, in some embodiments, be chosen for ease of removal, and, for example, may consist of a carbon-based dielectric material, such as a carbide.

FIG. 3D depicts S440 in the process of FIG. 4 where openings 310 are formed within the sacrificial dielectric 304. The openings 310 may be formed, for example, by use of etch process, such as wet-etch processes using chemicals and dry-etch processes using reactive plasma, as well as any other suitable method of removal. In some embodiments, this process may be used in combination with a masking step, such as a photoresist mask formed using a lithographic process to selectively cover portions of the first semiconductor device 100, as well as any other suitable method for patterning the sacrificial dielectric 304. In some embodiments, a dry-etch may be suitable for removal of the sacrificial dielectric 304 when the sacrificial dielectric 304 is formed of a carbon material. The relative size of the openings 310 in the X-Y dimension may be large, with the openings extending between two of the one or more cell electrodes 130, and extending along the trench 301 beyond either of the one or more source side isolation layers 102 and the one or more drain side isolation layers 112. The large relative size in the X-Y dimension of the openings 310 may thus provide a larger critical dimension for additional steps than otherwise defined by the spacing between each of the one or more cell electrodes 130, and may allow a smaller aspect ratio in the interelectrode isolation layer 105 than defined by the spacing between each of the one or more cell electrodes 130.

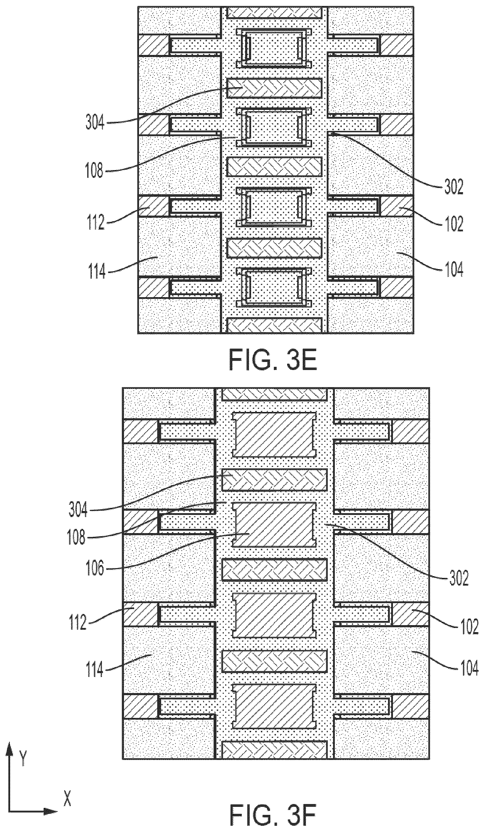

FIG. 3E depicts S450 in the process of FIG. 4, where the second dielectric material 108 is deposited within the openings 310. In some embodiments, the openings 310 in the sacrificial dielectric 304 may operate as a mold to shape the second dielectric material 108. The second dielectric material 108 may be formed using a conformal process such as ALD, as well as any other suitable process. The second dielectric material 108 may form a coating over the exposed surfaces of the openings 310, including both the liner layer 302 and the sacrificial dielectric 304. The second dielectric material 108 may be formed from the same or substantially the same material as the liner layer 302. When the second dielectric material 108 and the liner layer 302 are formed from the same material, the layers may form a combined layer extending from between the one or more cell electrodes 130 to the openings 310. In some embodiments, the second dielectric material 108 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant. The conformal deposition of the second dielectric material 108 may leave a portion of the openings 310 still open for additional deposition.

FIG. 3F depicts S460 in the process of FIG. 4, where the first dielectric material 106 is deposited within the remainder of the openings 310. In some embodiments, the openings in the second dielectric material 108 may operate as a mold to shape the first dielectric material 106. The first dielectric material 106 may fill the remainder of the openings 310, and be surrounded by the second dielectric material 108. In some embodiments, the first dielectric material 106 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant. The first dielectric material 106 may be formed by ALD, CVD, and any other suitable process for forming a dielectric in a semiconductor device. The first dielectric material 106 may be formed to have substantially the same width as the one or more source side isolation layers 102 or the one or more drain side isolation layers 112, such that the spacing between respective segments of the first dielectric material 106 may be equal to width of the one or more cell electrodes 130. In some embodiments, the width of the first dielectric material 106 may be larger or smaller than the one or more source side isolation layers 102 or the one or more drain side isolation layers 112, such that the spacing between respective segments of the first dielectric material 106 may be larger or smaller than the width of the one or more cell electrodes 130.

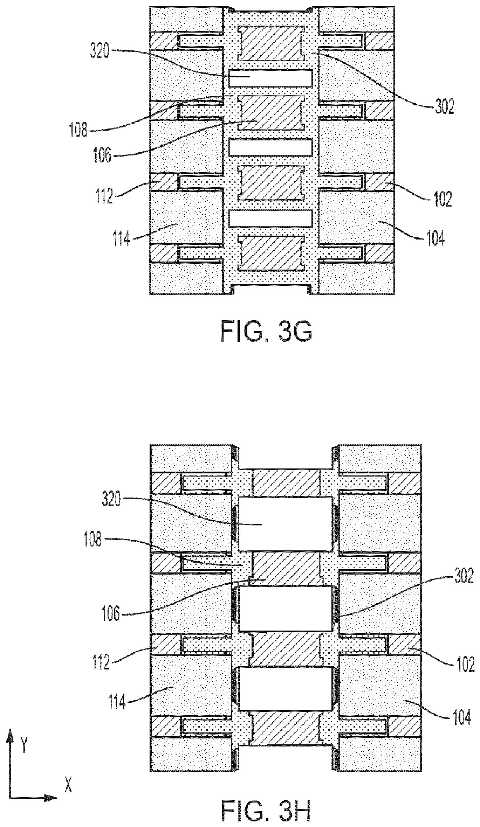

FIG. 3G depicts S470 in the process of FIG. 4, where the remainder of the sacrificial dielectric 304 is removed. The remainder of the sacrificial dielectric 304 may be removed by any suitable process including etch processes, such as wet-etch processes using chemicals and dry-etch processes using reactive plasma, as well as any other suitable method of removal. The openings formed by the removal of the remainder of the sacrificial dielectric 304 may be referred to as interconductive openings 320.

FIG. 3H depicts S480 in the process of FIG. 4, where the first dielectric material 106 and the second dielectric material 108 are trimmed down to size while the interconductive openings 320 are expanded to match the size of the one or more cell electrodes 130. The first dielectric material 106 and the second dielectric material 108 may be trimmed by any suitable process including etch processes, such as wet-etch processes using chemicals and dry-etch processes using reactive plasma, as well as any other suitable method of removal. In some embodiments, the materials forming the first dielectric material 106 and the second dielectric material 108 may differ such that an etchant effective against the second dielectric material 108 may be ineffective against the first dielectric material 106, such that the boundary between the first dielectric material 106 and the second dielectric material 108 acts as an etch stop. In some embodiments, the boundary between the first dielectric material 106 and the second dielectric material 108 may be a self-aligned etch stop.

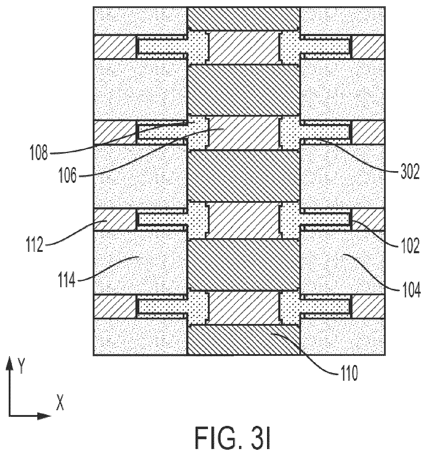

FIG. 3I depicts S490 in the process of FIG. 4 where, after the interconductive openings 320 are expanded, a conductive material is deposited within the interconductive openings 320 to form the one or more vertical electrodes 110. The conductive material may include doped semiconductor materials, metals such as tungsten, functionalized carbon nanomaterials, as well as any other suitable conductive material. In some embodiments, the conductive material of the one or more vertical electrodes 110 may be formed by a semiconductor process such as CVD, ALD, physical vapor deposition (PVD), electroplating, or any other suitable method for forming a conductive material.

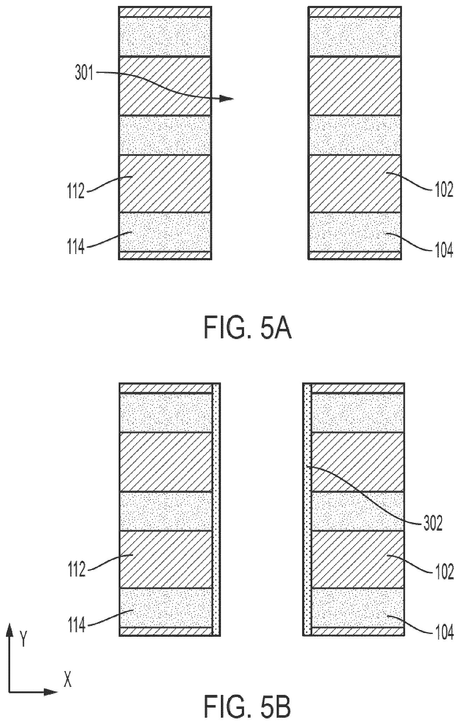

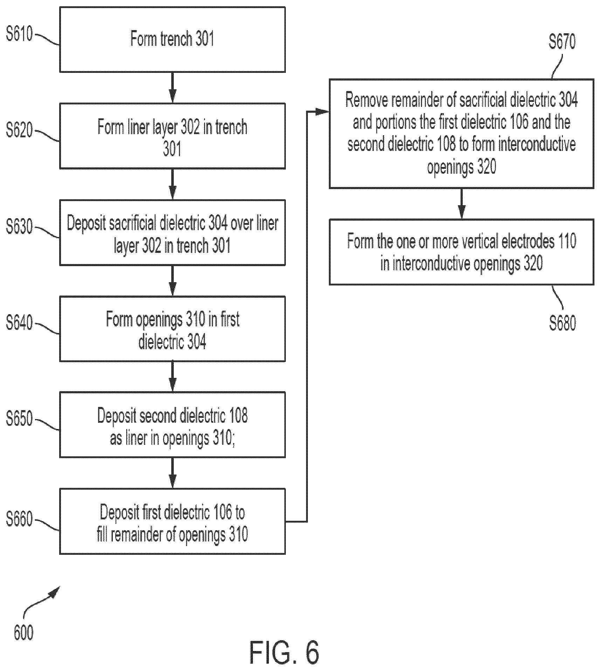

FIG. 5A-5H depict an illustrative embodiment of a process of forming a semiconductor device such as the second semiconductor device 200, or any other semiconductor devices shown herein. FIG. 6 depicts a flowchart of a method forming a semiconductor structure according to various embodiments of the subject matter disclosed herein. FIG. 6 depicts an example embodiment of a process 600 for forming a semiconductor device corresponding to the illustrative embodiment of FIGS. 5A-5H. The process 600 varies largely from the process 400 by using the same material in the first dielectric material 106 as the liner layer 302.

FIG. 5A depicts S610 in the process of FIG. 6, where a trench 301 is formed within the first semiconductor device 100; the trench 301 separates the one or more cell electrodes 130 into the one or more source side cell electrodes 104 and the one or more drain side cell electrodes 114. The trench 301 may be formed using any suitable semiconductor process, and may include techniques such as etching, including both wet-etch processes using chemicals and dry-etch processes using reactive plasma, as well as lithography, mechanical drilling or cutting, lasers, and a combination of these methods and any other suitable methods known in the art. The trench 301 may have a width between the one or more source side cell electrodes 104 and the one or more drain side cell electrodes 114 of approximately 150 nm but may vary in other embodiments to a width of between 1 nm and 10 microns, as appropriate. In the embodiment of FIG. 5A, the trench 301 is depicted as an opening extending in the X-Y direction between the one or more source side cell electrodes 104 and the one or more drain side cell electrodes 114. However, in some embodiments the trench 301 may not extend beyond the one or more source side cell electrodes 104 and the one or more drain side cell electrodes 114, forming a planar surface.

FIG. 5B depicts S620 in the process of FIG. 6, where a liner layer 302 is deposited over the surface of the trench 301. The liner layer 302 may be a conformal layer to cover exposed surfaces within the trench 301. The liner layer 302 may be formed by any suitable process, such as chemical vapor deposition (CVD), atomic layer deposition (ALD), or any other suitable method known in the art. In some embodiments, the material of the liner layer 302 may be chosen for depositional compatibility with the one or more source side isolation layers 102 and the one or more drain side isolation layers 112. In some embodiments, the material of the liner layer 302 may be a dielectric material and may be substantially similar to the first dielectric material 106 or the second dielectric material 108. In some embodiments, the liner layer 302 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant.

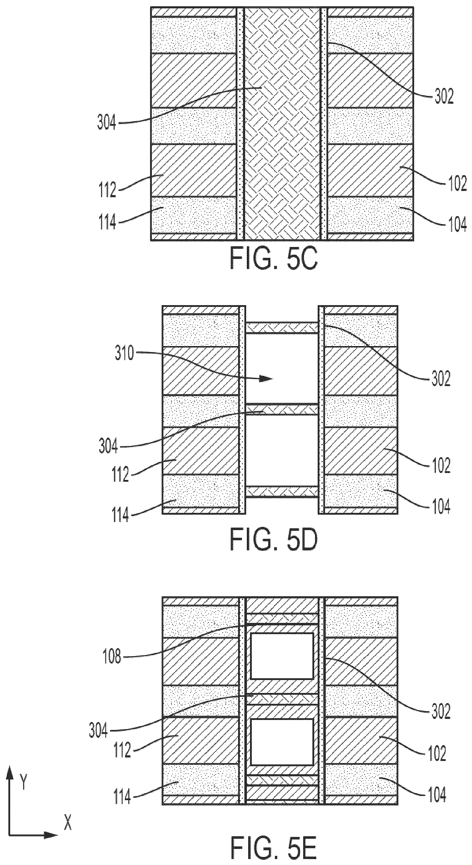

FIG. 5C depicts S630 in the process of FIG. 6, where a sacrificial dielectric 304 is deposited within the trench 301 and over the liner layer 302. The sacrificial dielectric 304 is deposited using a process such as CVD, ALD, or any other suitable method to fill the remainder of the trench 301. The sacrificial dielectric 304 may, in some embodiments, be chosen for ease of removal, and, for example, may consist of a carbon-based dielectric material, such as a carbide.

FIG. 5D depicts S640 in the process of FIG. 6, where openings 310 are formed within the sacrificial dielectric 304. The openings 310 may be formed, for example, by use of etch process, such as wet-etch processes using chemicals and dry-etch processes using reactive plasma, as well as any other suitable method of removal. In some embodiments, may be used in combination with a masking step, such as a photoresist mask formed using a lithographic process to selectively cover portions of the first semiconductor device 100, as well as any other suitable method for patterning the sacrificial dielectric 304. In some embodiments, a dry-etch may be suitable for removal of the sacrificial dielectric 304 when the sacrificial dielectric 304 is formed of a carbon material. The relative size of the openings 310 in the X-Y direction may be large, with the openings extending between two of the one or more cell electrodes 130, and extending along the trench 301 beyond either of the one or more source side isolation layers 102 and the one or more drain side isolation layers 112. The large relative size of the openings 310 in the X-Y direction may thus provide a larger critical dimension for additional steps than otherwise defined by the spacing between each of the one or more cell electrodes 130, and may allow a smaller aspect ratio in the interelectrode isolation layer 105 than defined by the spacing between each of the one or more cell electrodes 130.

FIG. 5E depicts S650 in the process of FIG. 6, where the second dielectric material 108 is deposited within the openings 310. In some embodiments, the openings 310 in the sacrificial dielectric 304 may operate as a mold to shape the second dielectric material 108. The second dielectric material 108 may be formed using a conformal process such as ALD, as well as any other suitable process. The second dielectric material 108 may form a coating over the exposed surfaces of the openings 310, including both the liner layer 302 and the sacrificial dielectric 304. In FIG. 5E, the second dielectric material 108 may be formed from a different material as the liner layer 302. In some embodiments, the second dielectric material 108 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant. The conformal deposition of the second dielectric material 108 may leave a portion of the openings 310 still open for additional deposition.

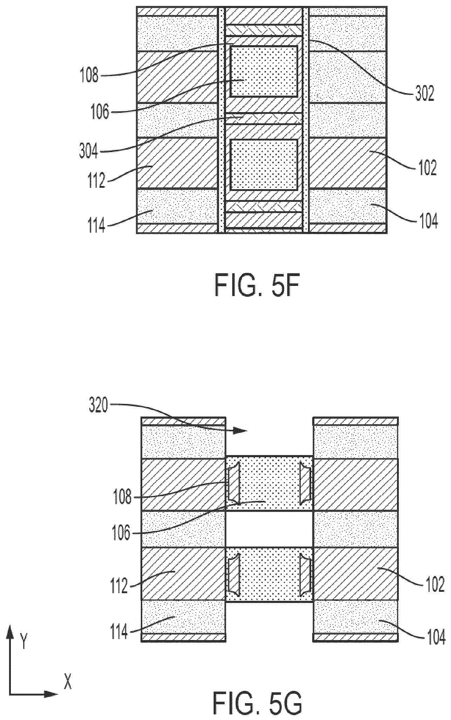

FIG. 5F depicts S660 in the process of FIG. 6, where the first dielectric material 106 is deposited within the remainder of the openings 310. In some embodiments, the openings in the second dielectric material 108 may operate as a mold to shape the first dielectric material 106. The first dielectric material 106 may fill the remainder of the openings 310, and be surrounded by the second dielectric material 108. The first dielectric material 106 may be formed from the same or substantially the same material as the liner layer 302. The first dielectric material 106 may be formed by ALD, CVD, and any other suitable process for forming a dielectric in a semiconductor device. The first dielectric material 106 may be chosen to have substantially the same width as the one or more source side isolation layers 102 or the one or more drain side isolation layers 112, such that the spacing between respective segments of the first dielectric material 106 may be equal to width of the one or more cell electrodes 130. In some embodiments, the width of the first dielectric material 106 may be larger or smaller than the one or more source side isolation layers 102 or the one or more drain side isolation layers 112, such that the spacing between respective segments of the first dielectric material 106 may be larger or smaller than the width of the one or more cell electrodes 130.

FIG. 5G depicts S670 in the process of FIG. 6, where the remainder of the sacrificial dielectric 304 and portions of the first dielectric material 106 and the second dielectric material 108 may be removed to form interconductive openings 320. The remainder of the sacrificial dielectric 304 and portions of the first dielectric material 106 and the second dielectric material 108 may be removed by any suitable process including etch processes, such as wet-etch processes using chemicals and dry-etch processes using reactive plasma, as well as any other suitable method of removal. The openings formed by the removal of the remainder of the sacrificial dielectric 304 and portions of the first dielectric material 106 and the second dielectric material 108 may be referred to as interconductive openings 320. In some embodiments, the first dielectric material 106 and the second dielectric material 108 may be removed by the same etchant process as removes the remainder of the sacrificial dielectric 304, while in other embodiments, multiple etchant steps may be used, with a separate etching step for the remainder of the sacrificial dielectric 304 and one or more etching steps for removing portions of the first dielectric material 106 and the second dielectric material 108. In some embodiments, the materials forming the sacrificial dielectric 304, the first dielectric material 106 and the second dielectric material 108 may differ such that an etchant effective against the second dielectric material 108 or the sacrificial dielectric 304 may be ineffective against the first dielectric material 106, such that the boundary between the first dielectric material 106 and the second dielectric material 108 acts as an etch stop. In some embodiments, the boundary between the first dielectric material 106 and the second dielectric material 108 may be a self-aligned etch stop

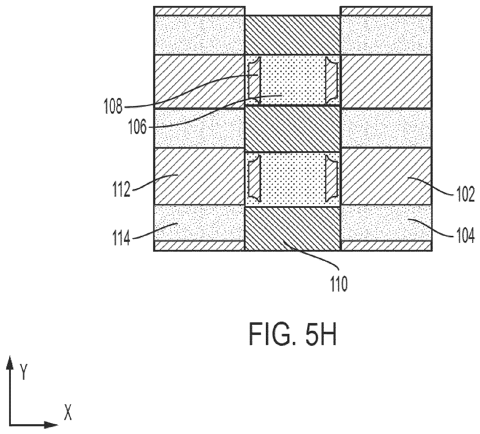

FIG. 5H depicts S680 in the process of FIG. 6, where after the interconductive openings 320 are expanded, a conductive material is deposited within the interconductive openings 320 to form the one or more vertical electrodes 110. The conductive material may include doped semiconductor materials, metals such as tungsten, functionalized carbon nanomaterials, as well as any other suitable conductive material. In some embodiments, the conductive material of the one or more vertical electrodes 110 may be formed by a semiconductor process such as CVD, ALD, physical vapor deposition (PVD), electroplating, or any other suitable method for forming a conductive material.

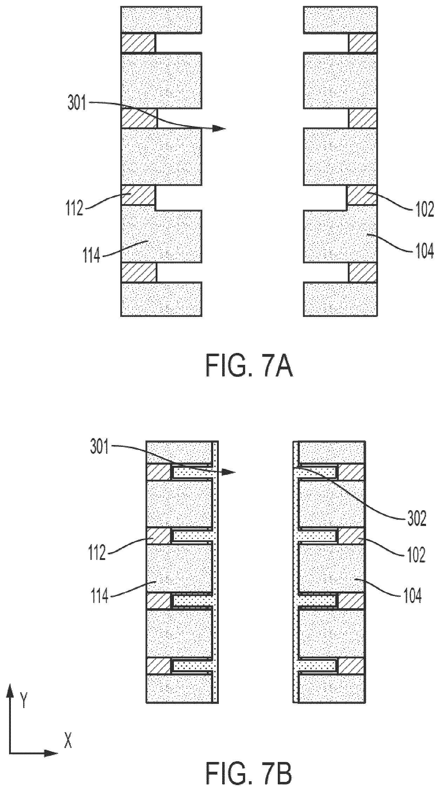

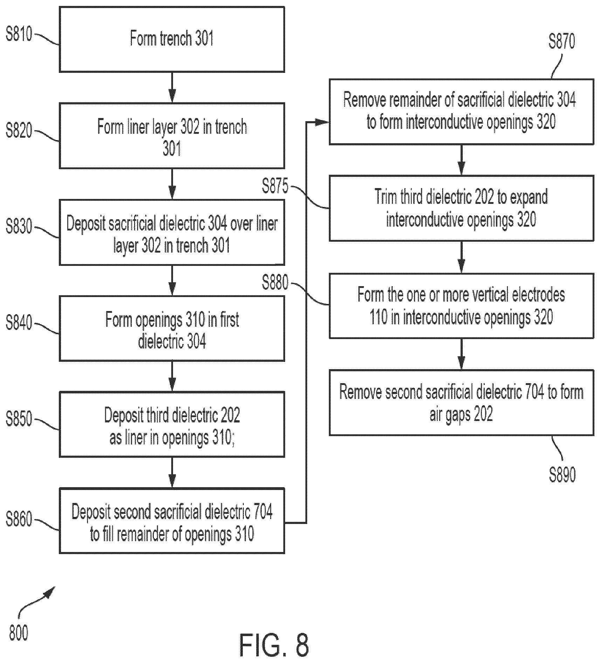

FIGS. 7A-7J depict cross-section views of an example embodiment of a semiconductor structure at different stages of its manufacture. FIG. 7A-7J depict an illustrative embodiment of a process of forming a semiconductor device such as a third semiconductor device 300. FIG. 8 depicts an example embodiment of a process 800 for forming a semiconductor device corresponding to the illustrative embodiment of FIGS. 7A-7J.

FIG. 7A depicts S810 in the process of FIG. 8, where a trench 301 is formed within the first semiconductor device 100, the trench 301 separates the one or more cell electrodes 130 into the one or more source side cell electrodes 104 and the one or more drain side cell electrodes 114. The trench 301 may be formed using any suitable semiconductor process, and may include techniques such as etching, including both wet-etch processes using chemicals and dry-etch processes using reactive plasma, as well as lithography, mechanical drilling or cutting, lasers, and a combination of these methods and any other suitable methods known in the art. The trench 301 may have a width between the one or more source side cell electrodes 104 and the one or more drain side cell electrodes 114 of approximately 150 nm but may vary in other embodiments to a width of between 1 nm and 10 microns, as appropriate. In the embodiment of FIG. 7A, the trench 301 is depicted as extending between the one or more source side cell electrodes 104 and the one or more drain side cell electrodes 114. However, in some embodiments the trench 301 may not extend beyond the one or more source side cell electrodes 104 and the one or more drain side cell electrodes 114, forming a planar surface.

FIG. 7B depicts S820 in the process of FIG. 8, where a liner layer 302 is deposited over the surface of the trench 301. The liner layer 302 may be a conformal layer to cover exposed surfaces within the trench 301. The liner layer 302 may be formed by any suitable process, such as chemical vapor deposition (CVD), atomic layer deposition (ALD), or any other suitable method known in the art. In some embodiments, the material of the liner layer 302 may be chosen for depositional compatibility with the one or more source side isolation layers 102 and the one or more drain side isolation layers 112. In some embodiments, the material of the liner layer 302 may be a dielectric material and may be substantially similar to the first dielectric material 106 or the second dielectric material 108. In some embodiments, the liner layer 302 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant.

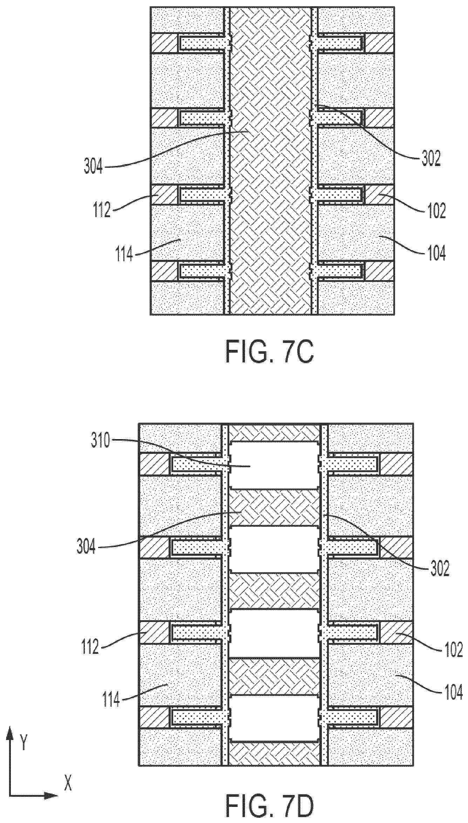

FIG. 7C depicts S830 in the process of FIG. 8, where a sacrificial dielectric 304 is deposited within the trench 301 and over the liner layer 302. The sacrificial dielectric 304 is deposited using a process such as CVD, ALD, or any other suitable method to fill the remainder of the trench 301. The sacrificial dielectric 304 may, in some embodiments, be chosen for ease of removal, and, for example, may consist of a carbon-based dielectric material, such as a carbide.

FIG. 7D depicts S840 in the process of FIG. 8, where openings 310 are formed within the sacrificial dielectric 304. The openings 310 may be formed, for example, by use of etch process, such as wet-etch processes using chemicals and dry-etch processes using reactive plasma, as well as any other suitable method of removal. In some embodiments, may be used in combination with a masking step, such as a photoresist mask formed using a lithographic process to selectively cover portions of the first semiconductor device 100, as well as any other suitable method for patterning the sacrificial dielectric 304. In some embodiments, a dry-etch may be suitable for removal of the sacrificial dielectric 304 when the sacrificial dielectric 304 is formed of a carbon material. The relative size of the openings 310 in the X-Y direction may be large, with the openings extending between two of the one or more cell electrodes 130, and extending along the trench 301 beyond either of the one or more source side isolation layers 102 and the one or more drain side isolation layers 112. The large relative size of the openings 310 in the X-Y direction may thus provide a larger critical dimension for additional steps than otherwise defined by the spacing between each of the one or more cell electrodes 130, and may allow a smaller aspect ratio in the interelectrode isolation layer 105 than defined by the spacing between each of the one or more cell electrodes 130.

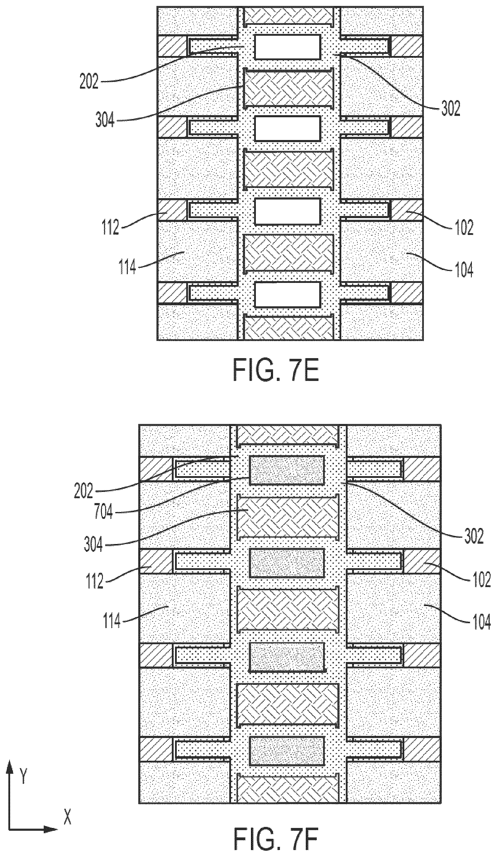

FIG. 7E depicts S850 in the process of FIG. 8, where the third dielectric material 202 is deposited within the openings 310. In some embodiments, the openings 310 in the sacrificial dielectric 304 may operate as a mold to shape the third dielectric material 202. The third dielectric material 202 may be formed using a conformal process such as ALD, as well as any other suitable process. The third dielectric material 202 may form a coating over the exposed surfaces of the openings 310, including both the liner layer 302 and the sacrificial dielectric 304. The third dielectric material 202 may be formed from the same or substantially the same material as the liner layer 302. When the third dielectric material 202 and the liner layer 302 are formed from the same material, the layers may form a combined layer extending from between the one or more cell electrodes 130 to the openings 310. In some embodiments, the third dielectric material 202 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant. The conformal deposition of the third dielectric material 202 may leave a portion of the openings 310 still open for additional deposition. The third dielectric material 202 may be chosen to have substantially the same width as the one or more source side isolation layers 102 or the one or more drain side isolation layers 112, such that the spacing between respective segments of the third dielectric material 202 may be equal to width of the one or more cell electrodes 130. In some embodiments, the width of the third dielectric material 202 may be larger or smaller than the one or more source side isolation layers 102 or the one or more drain side isolation layers 112, such that the spacing between respective segments of the third dielectric material 202 may be larger or smaller than the width of the one or more cell electrodes 130.

FIG. 7F depicts S860 in the process of FIG.8, where a second sacrificial dielectric material 704 is deposited within the remainder of the openings 310. In some embodiments, the openings within the third dielectric material 202 may form a mold for the second sacrificial dielectric material 704. The second sacrificial dielectric material 704 may fill the remainder of the openings 310, and be surrounded by the second dielectric material 108. In some embodiments, the second sacrificial dielectric material 704 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant. The second sacrificial dielectric material 704 may be formed by ALD, CVD, and any other suitable process for forming a dielectric in a semiconductor device.

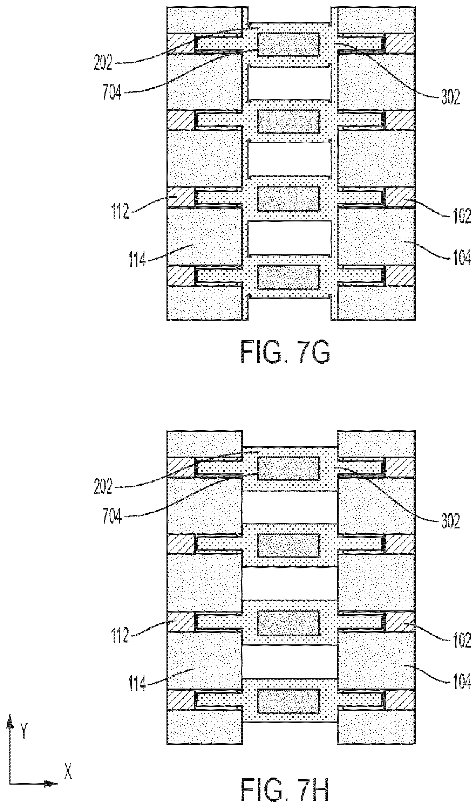

FIG. 7G depicts S870 in the process of FIG. 8, where the remainder of the sacrificial dielectric 304 is removed. The remainder of the sacrificial dielectric 304 may be removed by any suitable process including etch processes, such as wet-etch processes using chemicals and dry-etch processes using reactive plasma, as well as any other suitable method of removal. The openings formed by the removal of the remainder of the sacrificial dielectric 304 may be referred to as interconductive openings 320. In some embodiments, the materials forming the third dielectric material 202 and the sacrificial dielectric 304 may differ such that an etchant effective against the sacrificial dielectric 304 may be ineffective against the third dielectric material 202, such that the boundary between the third dielectric material 202 and the sacrificial dielectric 304 acts as an etch stop. In some embodiments, the boundary between the third dielectric material 202 and the sacrificial dielectric 304 may be a self-aligned etch stop.

FIG. 7H depicts S875 in the process of FIG. 8, where after the sacrificial dielectric 304 is removed, the third dielectric material 202 is trimmed, widening the interconductive openings 320. The trim may be performed by any suitable process including etch processes, such as wet-etch processes using chemicals and dry-etch processes using reactive plasma, as well as any other suitable method of removal. The interconductive openings 320 may be widened such that the third dielectric material 202 may be removed between the one or more source side cell electrodes 104 and one or more drain side cell electrodes 114.

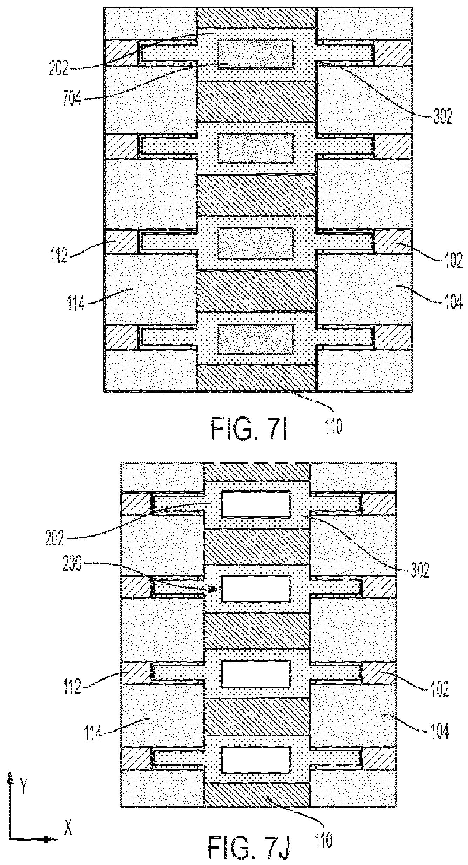

FIG. 7I depicts S880 in the process of FIG. 8, where after the interconductive openings 320 are formed, a conductive material is deposited within the interconductive openings 320 to form the one or more vertical electrodes 110. The conductive material may include doped semiconductor materials, metals such as tungsten, functionalized carbon nanomaterials, as well as any other suitable conductive material. In some embodiments, the conductive material of the one or more vertical electrodes 110 may be formed by a semiconductor process such as CVD, ALD, physical vapor deposition (PVD), electroplating, or any other suitable method for forming a conductive material.

FIG. 7J depicts S890 in the process of FIG. 8, where the second sacrificial dielectric material 704 is removed to form the air gap 230 in the space previously occupied by the second sacrificial dielectric material 704. The second sacrificial dielectric material 704 may be removed by any suitable process including etch processes, such as wet-etch processes using chemicals and dry-etch processes using reactive plasma, as well as any other suitable method of removal. In some embodiments, the materials forming the third dielectric material 202 and the second sacrificial dielectric material 704 may differ such that an etchant effective against the second sacrificial dielectric material 704 may be ineffective against the third dielectric material 202, such that the boundary between the third dielectric material 202 and the second sacrificial dielectric material 704 acts as an etch stop. In some embodiments, the boundary between the third dielectric material 202 and the second sacrificial dielectric material 704 may be a self-aligned etch stop.

In some embodiments, the air gap 230 may be filled by subsequent processing. In some embodiments a fluid may fill the air gap 230, while in other embodiments an additional solid dielectric material may be used to fill the air gap 230. In some embodiments, the air gap 230 may be open to the ambient environment, while in other embodiments, the air gap 230 may be closed from the ambient environment. In some embodiments, the air gap 230 may be closed from the ambient environment and be evacuated to form at least a partial vacuum within. As the relative permittivity (εᵣ) of air and vacuum are relatively close to 1 (εᵣ~1), the effective relative permittivity the interelectrode isolation layer 105 may be reduced, which in turn may thus reduce the parasitic capacitance between the one or more vertical electrodes 110.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific example teachings discussed above, but is instead defined by the following claims.

## Claims

1. A device comprising:
a first electrode;
a second electrode extending in a direction parallel to the first electrode;
a first dielectric material disposed between the first electrode and the second electrode;
a second dielectric material disposed between the first electrode and the second electrode; and
a third electrode contacting the first electrode, the third electrode extending in a direction orthogonal to the first electrode and the second electrode; and
a fourth electrode contacting the second electrode, the fourth electrode extending in a direction parallel to the third electrode;
wherein the first dielectric material is disposed between the third electrode and the fourth electrode, wherein the second dielectric material is disposed between the first dielectric material and the third electrode, and wherein the second dielectric material is disposed between the first dielectric material and the fourth electrode.

2. The device of claim 1, wherein the first dielectric material comprises one or more of a carbide, nitride or oxide; and
wherein the second dielectric material comprises one or more of a carbide, nitride or oxide.

3. The device of claim 1 or 2, wherein the first dielectric material and the second dielectric material comprise differing materials.

4. The device of any one of claims 1 to 3, wherein the first electrode comprises a vertical bit line electrode; and
wherein the third electrode comprises a cell electrode.

5. The device of any one of claims 1 to 4, wherein the first dielectric material extends in a direction parallel to the first electrode; and
wherein the second dielectric material extends in a direction parallel to the first electrode.

6. The device of any one of claims 1 to 5, wherein the second dielectric material is disposed between the first dielectric material and the first electrode and wherein the second dielectric material is disposed between the first dielectric material and the second electrode.

7. The device of any one of claims 1 to 6, wherein the second dielectric material comprises an air gap.

8. A system comprising:
a first electrode;
a second electrode extending in a direction parallel to the first electrode;
a dielectric interlayer disposed between the first electrode and the second electrode, the dielectric interlayer defining an air gap;
a third electrode extending in a direction orthogonal to the first electrode and the second electrode; and
a fourth electrode extending in a direction parallel to the third electrode;
wherein the air gap is disposed between the third electrode and the fourth electrode.

9. The system of claim 8, wherein the dielectric interlayer comprises one or more of a carbide, nitride or oxide.

10. The system of claim 8 or 9, wherein the dielectric interlayer extends in a direction parallel to the first electrode; and
wherein the air gap extends in a direction parallel to the first electrode.

11. The system of any one of claims 8 to 10, wherein the dielectric interlayer is disposed between the third electrode and the fourth electrode; and
wherein the dielectric interlayer extends in a direction parallel to the third electrode.

12. A method comprising:
forming a trench;
forming a first dielectric within the trench;
depositing a second dielectric within the trench to form a mold;
depositing a third dielectric within the mold;
removing portions of the first dielectric to form one or more conductive openings; and
depositing a conductor within the one or more conductive openings.

13. The method of claim 12, wherein the first dielectric and the second dielectric are comprised of the same material.

14. The method of claim 12 or 13, wherein the first dielectric and the third dielectric are comprised of the same material.

15. The method of any one of claims 12 to 14, further comprising, after depositing the conductor within the one or more conductive openings, removing the third dielectric to form an air gap.
